# EUROPEAN PATENT APPLICATION

(11) **EP 3 041 009 A1**
(43) Date of publication of application: **06.07.2016**
(21) Application number: 14840729.9
(22) Date of filing: 25.08.2014
(51) Int. Cl.: H01G 9/20

(54) **LIGHT POWER GENERATION DEVICE AND METHOD FOR MANUFACTURING SAME**

(30) Priority: 26.08.2013 JP 2013175004
(71) Applicant: Zeon Corporation, Tokyo 100-8246 (JP)
(72) Inventor: KOJIMA, Kiyoshige, Tokyo 100-8246 (JP)
(74) Representative: Vossius & Partner Patentanwälte Rechtsanwälte mbB
(86) International application number: PCT/JP2014/004360
(87) International publication number: WO 2015/029415

(57) **Abstract**

A photovoltaic device includes two or more layers of organic photoelectric conversion module base plates that are stacked and connected, and that each include one or more photoelectric conversion elements. From 20% to 80% of area of each of the organic photoelectric conversion module base plates is occupied by a photoelectric conversion element section.

## Description

### TECHNICAL FIELD

The present disclosure relates to a photovoltaic device including two or more layers of organic photoelectric conversion module base plates that are stacked and connected, and to a method for manufacturing the photovoltaic device.

### BACKGROUND

A photoelectric conversion module that uses solar cells as photoelectric conversion elements is a known conventional example of a photoelectric conversion module that converts light energy, such as solar energy, to electrical energy. The solar cells are for example silicon (Si) solar cells.

In recent years, organic solar cells such as dye-sensitized solar cells and organic thin-film solar cells have attracted attention as alternatives to Si solar cells and the like.

Among such organic solar cells, dye-sensitized solar cells have received particular attention as they are expected to be lighter in weight than, for example, Si solar cells, are capable of generating electricity reliably over a wide illumination range, and can be manufactured from relatively cheap materials without the need for large-scale equipment.

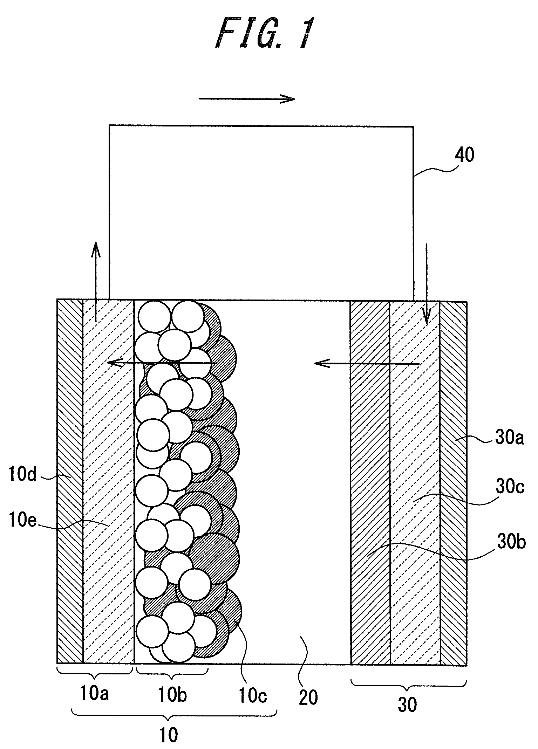

A dye-sensitized solar cell such as described above typically has a structure in which a photoelectrode 10, an electrolyte layer 20, and a counter electrode 30 are arranged in the stated order as illustrated in FIG. 1. The dye-sensitized solar cell has a mechanism in which electrons are removed from a sensitizing dye in the photoelectrode 10 upon the sensitizing dye receiving light and the removed electrons move out of the photoelectrode 10 along an external circuit 40 to the counter electrode 30, before subsequently moving into the electrolyte layer 20.

It should be noted that in FIG. 1, reference sign 10a indicates a photoelectrode base plate, reference sign 10b indicates a porous semiconductor fine particulate layer, reference sign 10c indicates a sensitizing dye layer, reference signs 10d and 30a indicate supports, reference signs 10e and 30c indicate conductive films, and reference sign 30b indicates a catalyst layer.

Unfortunately, dye-sensitized solar cells have low photoelectric conversion efficiency and poor electricity generation efficiency compared to, for example, Si solar cells. Consequently, a plurality of dye-sensitized solar cells may be connected to one another in order to improve electricity generation.

Examples of the above technique are provided by PTL 1 and PTL 2, which disclose vertically-stacked dye-sensitized solar cell modules that each include a stack of dye-sensitized solar cells in which adjacent dye-sensitized solar cells in the stacking direction are electrically connected to one another.

### CITATION LIST

### Patent Literature

PTL 1: JP2008-130547
PTL 2: JP2013-098005

### SUMMARY

### (Technical Problem)

In the vertically-stacked dye-sensitized solar cell modules disclosed in PTL 1 and PTL 2 however, dye-sensitized solar cells serving as photoelectric conversion elements overlap with one another and light transmittance of the cells in generally low, which means that once light has passed through one cell, sufficient light does not reach another cell. Consequently, photoelectric conversion by the other cell is insufficient and the effective area of the cells contributing to photoelectric conversion in the module is reduced, which leaves room for further improvement in terms of increasing electricity generation.

The present disclosure was conceived in order to solve the problem described above and aims to provide a photovoltaic device having high electricity generation. The present disclosure also aims to provide a method for efficiently manufacturing the aforementioned photovoltaic device.

### (Solution to Problem)

The inventor performed diligent investigation in order to develop a photovoltaic device having high electricity generation.

As a result, the inventor discovered that in a configuration in which two or more layers of organic photoelectric conversion module base plates are stacked in order to increase electricity generation, electricity generation can be increased through from 20% to 80% of area of each of the organic photoelectric conversion module base plates being occupied by a photoelectric conversion element section and through the organic photoelectric conversion module base plates being connected such that light that has passed through an upper module base plate can be trapped and undergo photoelectric conversion in a lower module base plate.

In other words, the present disclosure provides configurations summarized below.

1. A photovoltaic device including two or more layers of organic photoelectric conversion module base plates that are stacked and connected, and that each include one or more photoelectric conversion elements, wherein

from 20% to 80% of area of each of the organic photoelectric conversion module base plates is occupied by a photoelectric conversion element section.

2. The photovoltaic device described in 1, wherein each of the organic photoelectric conversion module base plates further includes an open section, and
among organic photoelectric conversion module base plates that are adjacent in a stacking direction, at least part of an open section of an organic photoelectric conversion module base plate located on one side in the stacking direction overlaps in the stacking direction with at least part of a photoelectric conversion element section of an organic photoelectric conversion module base plate located on an opposite side in the stacking direction.

3. A method for manufacturing a photovoltaic device, including forming two or more electrically connected organic photoelectric conversion module base plate units on a transparent substrate and folding back between adjacent units to cause overlapping of the adjacent units, wherein each of the units includes one or more photoelectric conversion elements, and from 20% to 80% of area of each of the units is occupied by a photoelectric conversion element section.

4. The method for manufacturing a photovoltaic device described in 3, wherein each of the units further includes an open section, and open sections and photoelectric conversion element sections are provided in the adjacent units such that when folding back is performed between the adjacent units to cause overlapping of the adjacent units, among units that become adjacent in a stacking direction, at least part of an open section of a unit located on one side in the stacking direction overlaps in the stacking direction with at least part of a photoelectric conversion element section of a unit located on an opposite side in the stacking direction.

### (Advantageous Effect)

The present disclosure enables acquisition of a photovoltaic device having high electricity generation.

### BRIEF DESCRIPTION OF THE DRAWINGS

In the accompanying drawings:
FIG. 1 schematically illustrates an example of configuration of a conventional dye-sensitized solar cell;
FIG. 2 (a) to FIG. 2 (c) are cross-sectional views illustrating examples of a photovoltaic device of the present disclosure;
FIG. 3 is a plan view illustrating an organic photoelectric conversion module base plate included in a photovoltaic device of the present disclosure; and
FIG. 4 (a) to FIG. 4 (c) illustrate an exemplary process of a method for manufacturing a photovoltaic device of the present disclosure.

### DETAILED DESCRIPTION

The following provides a specific explanation. First, structure and the like of a photovoltaic device of the present disclosure are explained.

### <Photovoltaic device>

The photovoltaic device of the present disclosure includes two or more layers of organic photoelectric conversion module base plates that are stacked and electrically connected, and that each include one or more photoelectric conversion elements.

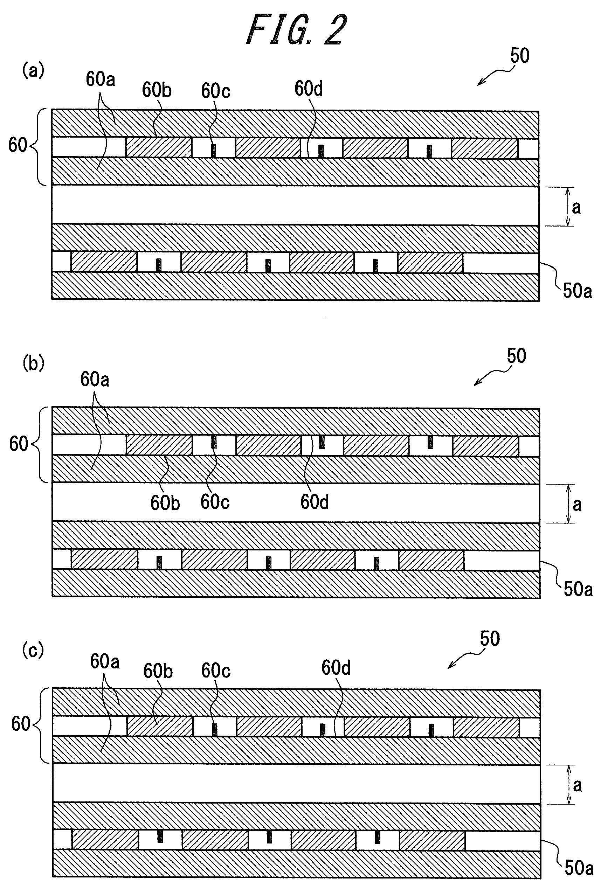

FIG. 2 is a cross-sectional view illustrating examples of the photovoltaic device of the present disclosure. As illustrated in FIG. 2, the organic photoelectric conversion module base plates in the photovoltaic device of the present disclosure can generally adopt three different stacking forms depending on positioning of collection wiring. As illustrated in FIG. 2, collection wiring is typically only located in contact with one out of a lower substrate and an upper substrate of an organic photoelectric conversion module base plate. However, collection wiring may alternatively be located in contact with both substrates and in such a situation, the organic photoelectric conversion module base plates only have one stacking form because there is no difference caused by positioning of the collection wiring.

It should be noted that in FIG. 2, reference sign 50 indicates the photovoltaic device, reference sign 50a indicates a side wall, reference sign 60 indicates an organic photoelectric conversion module base plate, reference sign 60a indicates substrates, reference sign 60b indicates a photoelectric conversion element, reference sign 60c indicates collection wiring, and reference sign 60d indicates an open section.

As illustrated in FIG. 2, the open section (inclusive of a collection wiring section) is normally a base plate region in which photoelectric conversion elements are not present. Although the open section may be hollow, it is generally preferable that the open section is sealed with a transparent resin such as described further below. An open section such as described above has higher light transmittance than a region in which a photoelectric conversion element is present. Therefore, organic photoelectric conversion module base plates that are adjacent in a stacking direction are preferably stacked such that at least part of an open section of an organic photoelectric conversion module base plate located on one side in the stacking direction overlaps in the stacking direction with at least part of photoelectric conversion elements of an organic photoelectric conversion module base plate located on an opposite side in the stacking direction.

The stacking described above can enable irradiated light to reach a lower module base plate more efficiently, can increase the effective area of photoelectric conversion elements contributing to photoelectric conversion, and can improve electricity generation.

Sufficiently high effective area of photoelectric conversion elements contributing to photoelectric conversion and high electricity generation can for example be achieved by adopting a configuration in which, among organic photoelectric conversion module base plates that are adjacent in the stacking direction, at least part of an open section of an organic photoelectric conversion module base plate located on one side in the stacking direction overlaps with at least part of photoelectric conversion elements of an organic photoelectric conversion module base plate located on an opposite side in the stacking direction, and in which an overlapping region of photoelectric conversion elements of an upper module base plate and a module base plate below the upper module base plate is preferably from 0% to 50%, and more preferably from 0% to 30%, of the area occupied by the photoelectric conversion elements in the lower module base plate. In particular, a configuration in which the photoelectric conversion elements of the upper module base plate and the lower module base plate partially overlap is favorable because the photoelectric conversion elements of the lower module base plate can trap light that is incident diagonally from the open section of the upper module base plate.

In a configuration in which three layers of organic photoelectric conversion module base plates (referred to as a first layer, a second layer, and a third layer in order from a direction in which light is irradiated) are stacked, the first layer is an upper module base plate and the second layer is a lower module base plate in a relationship between the first and second layers, and the second layer is an upper module base plate and the third layer is a lower module base plate in a relationship between the second and third layers. The same applies in a configuration in which four or more layers of organic photoelectric conversion module base plates are stacked.

From a viewpoint of optimizing electricity generation and manufacturing cost, it is preferable that the number of stacked layers of organic photoelectric conversion module base plates is approximately from 2 to 5 layers.

Furthermore, from a viewpoint of efficiently taking incident light into the lower module base plate, it is preferable that an interval "a" between the organic photoelectric conversion module base plates (distance between the upper module base plate and the lower module base plate, refer to FIG. 2) is in a range from 10 nm to 5 mm, and more preferably in a range from 100 nm to 3 mm.

Explanation is provided next for the organic photoelectric conversion module base plates included in the photovoltaic device of the present disclosure.

### <Organic photoelectric conversion module base plates>

Each of the organic photoelectric conversion module base plates included in the photovoltaic device of the present disclosure includes one or more photoelectric conversion elements.

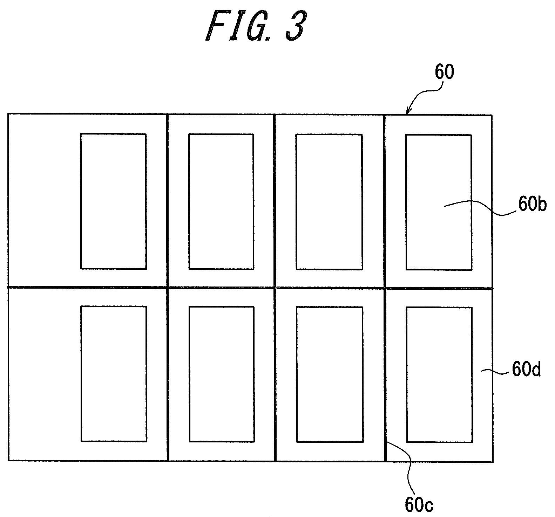

The organic photoelectric conversion module base plate for example has a configuration such as illustrated in FIG. 3, in which photoelectric conversion elements are arranged on a substrate that serves as a support and in which the photoelectric conversion elements are electrically connected to one another in series or parallel through collection wiring (not all of the wiring is illustrated). A base plate region in which the photoelectric conversion elements are not present is normally an open section (inclusive of a collection wiring section).

From a viewpoint of increasing light transmittance of the photoelectric conversion elements and the open section of the organic photoelectric conversion module base plate, it is preferable that the substrate is a transparent substrate. Examples of transparent substrates that can be used include a glass substrate and a transparent resin substrate made from a transparent resin such as described further below. Herein, the term "transparent" is used to refer to a light transmittance of at least 70% (preferably at least 80%). The light transmittance is a total light transmittance measured in accordance with JIS K7361-1.

From a viewpoint of balance between light transmittance and strength, it is preferable that the transparent substrate has a thickness in a range from 0.01 mm to 10 mm.

The following characteristic of the organic photoelectric conversion module base plate is one of the main features of the present disclosure.

From 20% to 80% of area of the organic photoelectric conversion module base plate is occupied by a photoelectric conversion element section.

In order to ensure sufficient electricity generation per layer of module base plates while also increasing light transmittance of the upper module base plate, ensuring sufficient light is incident on the lower module base plate, and increasing the effective area of photoelectric conversion elements contributing to electricity generation to improve device electricity generation, the photoelectric conversion element section is required to occupy from 20% to 80% of area of the organic photoelectric conversion module base plate used in the present disclosure. From a viewpoint of ensuring sufficient device performance while also simplifying formation of the photoelectric conversion elements and the collection wiring, and reducing manufacturing costs, the proportion of area occupied by the photoelectric conversion element section is preferably from 35% to 65%, and more preferably from 40% to 60%.

Herein, the proportion of area of the organic photoelectric conversion module base plate that is occupied by the photoelectric conversion element section is not necessarily the same for both the upper module base plate and the lower module base plate.

Explanation is provided next for the photoelectric conversion elements that are arranged in the organic photoelectric conversion module base plate described above.

### <Photoelectric conversion elements>

The photoelectric conversion elements arranged in the organic photoelectric conversion module base plate can be commonly known dye-sensitized solar cells or organic thin-film solar cells. However, use of dye-sensitized solar cells is more advantageous in terms of, for example, cost and ease of manufacture.

The following explains an example of a dye-sensitized solar cell that can be used.

### <Dye-sensitized solar cell>

As described further above with reference to FIG. 1, a dye-sensitized solar cell typically has a structure in which a photoelectrode (transparent electrode) 10, an electrolyte layer 20, and a counter electrode 30 are arranged in the stated order.

### ▪ Photoelectrode

The photoelectrode 10 includes a photoelectrode base plate 10a, a porous semiconductor fine particulate layer 10b formed on the photoelectrode base plate 10a, and a sensitizing dye layer 10c formed by a sensitizing dye adsorbed onto the surface of the porous semiconductor fine particulate layer.

The photoelectrode base plate 10a functions as a support for the porous semiconductor fine particulate layer 10b, etc., and also functions as a current collector.

The photoelectrode base plate 10a for example includes a transparent resin substrate or glass substrate as a support 10d and a conductive layer 10e stacked thereon that is made from a composite metal oxide such as indium tin oxide (ITO) or indium zinc oxide (IZO). Although no specific limitations are placed on the support 10d, the function of the support 10d is normally implemented by a substrate of an organic photoelectric conversion module base plate included in the photovoltaic device of the present disclosure.

Examples of transparent resins that can be used include synthetic resins such as cycloolefin polymer (COP), polyethylene terephthalate (PET), polyethylene naphthalate (PEN), syndiotactic polystyrene (SPS), polyphenylene sulfide (PPS), polycarbonate (PC), polyarylate (PAr), polysulfone (PSF), polyester sulfone (PES), polyetherimide (PEI), and transparent polyimide (PI).

The porous semiconductor fine particulate layer 10b is a porous layer that contains semiconductor fine particles. As a result of the layer being porous, sensitizing dye adsorption can be increased and a dye-sensitized solar cell having a high conversion efficiency can be more easily obtained.

Examples of semiconductor fine particles that can be used include particles of metal oxides such as titanium oxide, zinc oxide, and tin oxide.

The porous semiconductor fine particulate layer can be formed by a commonly known method such as a press method, a hydrothermal decomposition method, an electrophoretic deposition method, or a binder-free coating method.

The sensitizing dye layer 10c is a layer of a compound (sensitizing dye) that is adsorbed onto the surface of the porous semiconductor fine particulate layer 10b and that can transfer electrons to the porous semiconductor fine particulate layer 10b upon being excited by light. It should be noted that the same sensitizing dye may be used in each of the dye-sensitized solar cells forming the photoelectric conversion elements of the present disclosure, or different sensitizing dyes may be used in different dye-sensitized solar cells.

Examples of sensitizing dyes that can be used include organic dyes such as cyanine dyes, merocyanine dyes, oxonol dyes, xanthene dyes, squarylium dyes, polymethine dyes, coumarin dyes, riboflavin dyes, and perylene dyes, and metal complex dyes such as phthalocyanine complexes and porphyrin complexes of metals such as iron, copper, and ruthenium.

The sensitizing dye layer 10c can for example be formed by a commonly known method such as a method in which the porous semiconductor fine particulate layer 10b is immersed in a solution of the sensitizing dye or a method in which a solution of the sensitizing dye is applied onto the porous semiconductor fine particulate layer 10b.

It should be noted that so long as the photoelectrode can release electrons into the external circuit 40 as a result of receiving light, the photoelectrode is not limited to the photoelectrode illustrated in FIG. 1.

### ▪ Electrolyte layer

The electrolyte layer 20 is a layer that is provided in order to separate the photoelectrode 10 and the counter electrode 30, and also in order to enable efficient charge movement.

The electrolyte layer 20 typically contains a supporting electrolyte, a redox couple (i.e., a couple of chemical species that can be reversibly converted between in a redox reaction in the form of an oxidant and a reductant), a solvent, and so forth.

Examples of supporting electrolytes that can be used include salts having a cation such as a lithium ion, an imidazolium ion, or a quaternary ammonium ion.

The redox couple enables reduction of the oxidized sensitizing dye and examples thereof include chlorine compound/chlorine, iodine compound/iodine, bromine compound/bromine, thallium(III) ions/thallium(I) ions, ruthenium(III) ions/ruthenium(II) ions, copper(II) ions/copper(I) ions, iron(III) ions/iron(II) ions, cobalt(III) ions/cobalt(II) ions, vanadium(III) ions/vanadium(II) ions, manganic acid ions/permanganic acid ions, ferricyanide/ferrocyanide, quinone/hydroquinone, and fumaric acid/succinic acid.

Examples of solvents that can be used include solvents used for forming electrolyte layers in solar cells such as acetonitrile, methoxyacetonitrile, methoxypropionitrile, N,N-dimethylformamide, ethylmethylimidazolium bis(trifluoromethylsufonyl)imide, and propylene carbonate.

The electrolyte layer 20 can for example be formed by applying a solution (electrolyte solution) including the components of the electrolyte layer 20 onto the photoelectrode 10 or by preparing a cell including the photoelectrode 10 and the counter electrode 30 and then injecting the electrolyte solution into a gap between the electrodes.

### ▪ Counter electrode

The counter electrode 30 is for example formed by forming a conductive film 30c on a support 30a and forming a catalyst layer 30b on the conductive film 30c.

The support 30a and the conductive film 30c can for example be the same as described above for the photoelectrode base plate 10a. The catalyst layer 30b may be optionally provided to function as a catalyst for transferring electrons from the counter electrode to the electrolyte layer and is typically formed by a platinum thin-film. Furthermore, the function of the support 30a may be implemented by a substrate of an organic photoelectric conversion module base plate included in the photovoltaic device of the present disclosure.

It should be noted that the conductive film 30c is not essential in a configuration in which the catalyst layer 30b is conductive; however, provision of the conductive film 30c is preferable from a viewpoint of ensuring favorable electrical continuity.

Although the above has explained an example of a dye-sensitized solar cell that can be used in the present disclosure, it is highly advantageous in the present disclosure to adopt carbon nanotubes or metal nanoparticle-supporting carbon nanotubes in the catalyst layer of the counter electrode described above or to adopt conductors containing carbon nanotubes or containing carbon nanotubes and metal nanostructures as the conductive films of the photoelectrode and the counter electrode.

That is to say, compared to a configuration in which a conventional platinum thin-film or composite metal oxide such as indium tin oxide (ITO) is adopted, catalytic activity and conductivity can be raised, cell electricity generation efficiency can be increased, and a larger open section can for example be provided in the organic photoelectric conversion module base plate. Furthermore, producibility can be significantly improved by for example performing cell production by a roll-to-roll process. Therefore, device electricity generation can be improved while also enabling simplified manufacturing and reduced manufacturing cost.

The following explains the carbon nanotubes, the metal nanoparticle-supporting carbon nanotubes, and the conductors containing carbon nanotubes or containing carbon nanotubes and metal nanostructures.

### (1) Carbon nanotubes and metal nanoparticle-supporting carbon nanotubes

Although a platinum thin-film is typically used as the catalyst layer of the counter electrode, carbon nanotubes-in particular, carbon nanotubes (also referred to below as carbon nanotubes (A)) having an average diameter (Av) and a diameter standard deviation (σ) that satisfy 0.60 > 3σ/Av > 0.20 (preferably, 0.60 > 3σ/Av > 0.50)-and such carbon nanotubes (A) further supporting metal nanoparticles are examples of preferable alternative materials that can be used.

That is to say, use of such materials is highly advantageous for mass production because manufacturing cost can be substantially reduced compared to that of platinum thin-films, the catalyst layer can be formed through application and drying of a dispersion liquid in which carbon nanotubes are dispersed, the dispersion liquid has favorable application properties, processability accuracy is significantly improved, and high-speed application by a roll-to-roll process and processed film manufacture are facilitated.

In addition, compared to a configuration in which a conventional platinum thin-film is used, catalytic activity can be raised and cell electricity generation efficiency can be increased. Therefore, light transmittance of the module base plate can be increased, for example by increasing the size of the open section, while also maintaining a balance with manufacturability.

It should be noted that the term "carbon nanotubes (A)" is used herein as a general term for a carbon nanotube assembly of specific carbon nanotubes composing the carbon nanotubes (A) and the term "diameter" is used herein to refer to the external diameter of the specific carbon nanotubes. Furthermore, the average diameter (Av) and the diameter standard deviation (σ) are respectively an average value and a standard deviation obtained by measuring the diameter of 100 randomly selected carbon nanotubes through observation under a transmission electron microscope (average length described further below is an average value obtained by measuring length through the same method). In the present disclosure, the carbon nanotubes (A) that are used typically take a normal distribution when a plot is made of diameter measured as described above on a horizontal axis and frequency on a vertical axis, and a Gaussian approximation is made.

Herein, from a viewpoint of achieving excellent catalytic activity, the average diameter (Av) of the carbon nanotubes (A) described above is preferably at least 0.5 nm and no greater than 15 nm, and more preferably at least 1 nm and no greater than 10 nm.

In addition, the average length of the carbon nanotubes (A) is preferably from 0.1 µm to 1 cm, and more preferably from 0.1 µm to 1 mm. As a result of the average length of the carbon nanotubes (A) being in the range described above, carbon nanotube orientation can be improved and thin-film formation can be easily performed, thus facilitating formation of a catalyst layer having high activity.

The carbon nanotubes (A) preferably have a specific surface area of from 100 m²/g to 2,500 m²/g, and more preferably from 400 m²/g to 1,600 m²/g. Formation of a catalyst layer having high activity is facilitated by the specific surface area of the carbon nanotubes (A) being in the range described above.

The specific surface area of the carbon nanotubes (A) can be obtained through a nitrogen gas adsorption method.

The carbon nanotubes composing the carbon nanotubes (A) may be single-walled carbon nanotubes or multi-walled carbon nanotubes. However, carbon nanotubes having from one to five walls are preferable and single-walled carbon nanotubes are more preferable from a viewpoint of improving activity of the catalyst layer.

The carbon nanotubes composing the carbon nanotubes (A) may have a functional group such as a carboxyl group introduced onto the surface thereof. The functional group may be introduced by commonly known oxidation treatment using hydrogen peroxide, nitric acid, or the like.

Furthermore, the carbon nanotubes composing the carbon nanotubes (A) preferably have micropores. Among carbon nanotubes having micropores, carbon nanotubes having micropores that have a pore diameter of smaller than 2 nm are preferable. In terms of the amount of micropores present, the micropore volume as obtained through a method described below is preferably at least 0.4 mL/g, more preferably at least 0.43 mL/g, and particularly preferably at least 0.45 mL/g, and typically has an upper limit of approximately 0.65 mL/g. It is preferable that the carbon nanotubes have micropores such as described above from a viewpoint of improving catalytic activity. The micropore volume can for example be adjusted through appropriate alteration of a preparation method and preparation conditions of the carbon nanotubes.

Herein, "micropore volume (Vp)" can be calculated from equation (I)-Vp = (V/22,414) × (M/ρ)-by measuring a nitrogen adsorption and desorption isotherm of the carbon nanotubes at liquid nitrogen temperature (77 K) and by setting an amount of adsorbed nitrogen at a relative pressure P/P0 = 0.19 as V. It should be noted that P is a measured pressure at adsorption equilibrium, P0 is a saturated vapor pressure of liquid nitrogen at time of measurement, and, in equation (I), M is a molecular weight of 28.010 of the adsorbate (nitrogen), and ρ is a density of 0.808 g/cm³ of the adsorbate (nitrogen) at 77 K. The micropore volume can for example be easily obtained using a "BELSORP (registered trademark)-mini" (product of Bel Japan Inc.).

The carbon nanotubes (A) having the properties described above can for example be manufactured efficiently by, in a method (super growth method; refer to WO2006/011655) in which, during synthesis of carbon nanotubes through chemical vapor deposition (CVD) by supplying a feedstock compound and a carrier gas onto a substrate (also referred to below as a "substrate for CNT manufacture") having a catalyst layer for carbon nanotube manufacture (also referred to below as a "catalyst layer for CNT manufacture") on the surface thereof, catalytic activity of the catalyst layer for CNT manufacture is dramatically improved by providing a trace amount of an oxidizing agent in the system, forming the catalyst layer on the surface of the substrate through a wet process (carbon nanotubes obtained through the super growth method described above are also referred to below as a SGCNTs).

The carbon nanotubes (A) may support metal nanoparticles, which is expected to improve catalytic effect.

Examples of metal nanoparticles that can be used include nanoparticles of metals in groups 6 to 14 of the periodic table.

Examples of metals in groups 6 to 14 of the periodic table include Cr, Mn, Fe, Co, Ni, Cu, Zn, Ga, Ru, Rh, Pd, Ag, Cd, Sn, Sb, W, Re, Ir, Pt, Au, and Pb. Among the metals listed above, Fe, Co, Ni, Ag, W, Ru, Pt, Au, and Pd are preferable for obtaining a highly versatile oxidation/reduction catalyst.

Any one of the metals listed above or a combination of any two or more of the metals listed above may be used.

From a viewpoint of improving catalytic effect, the metal nanoparticles preferably have an average particle diameter from 0.5 nm to 15 nm and preferably have a particle diameter standard deviation of no greater than 1.5 nm.

Although no specific limitations are placed on the amount of supported metal nanoparticles, the amount is preferably at least 1 part by mass per 100 parts by mass of the carbon nanotubes (A). As a result of the amount of supported metal nanoparticles being at least 1 part by mass, even better catalytic activity can be achieved. Although it is thought that catalytic activity continues to increase with increasing amount of supported metal nanoparticles, when supporting ability of the carbon nanotubes (A) and economic factors are taken into account, an upper limit for the amount of metal nanoparticles is, in general, preferably no greater than 30,000 parts by mass per 100 parts by mass of the carbon nanotubes (A).

No specific limitations are placed on the method by which the metal nanoparticles are caused to be supported by the carbon nanotubes. For example, the metal nanoparticles can be caused to be supported by the carbon nanotubes through a commonly known method in which a metal precursor is reduced in the presence of the carbon nanotubes (A) to produce the metal nanoparticles.

More specifically, a dispersion liquid including water, the carbon nanotubes (A), and a dispersant is prepared and solvent is evaporated after addition of the metal precursor. Next, heating is performed under hydrogen gas flow to reduce the metal precursor, thereby efficiently obtaining a metal nanoparticle support of produced metal nanoparticles supported by the carbon nanotubes (A).

The catalyst layer of the counter electrode can for example be formed by preparing a dispersion liquid including the carbon nanotubes (A), applying the prepared dispersion liquid onto the support, and drying the applied film.

Examples of solvents that can be used to prepare the dispersion liquid include water, alcohols such as methanol, ethanol, and propanol, ketones such as acetone and methyl ethyl ketone, ethers such as tetrahydrofuran, dioxane, and diglyme, amides such as N,N-dimethylformamide, N,N-dimethylacetamide, N-methyl-2-pyrrolidone, and 1,3-dimethyl-2-imidazolidinone, and sulfur-containing solvents such as dimethyl sulfoxide and sulfolane. Any one of the solvents listed above or a combination of any two or more of the solvents listed above may be used.

The dispersion liquid may further include other components such as a binder, a conductive additive, a dispersant, and a surfactant. Commonly known components may be used as appropriate as such components.

The dispersion liquid can for example be prepared by mixing the carbon nanotubes (A) and other components, as required, in the solvent and dispersing the carbon nanotubes.

Mixing treatment or dispersing treatment can for example be carried out through a method using a nanomizer, an ultimizer, an ultrasonic disperser, a ball mill, a sand grinder, a dyno-mill, a spike mill, a DCP mill, a basket mill, a paint conditioner, or a high-speed stirring device.

Application of the dispersion liquid onto a substrate can for example be carried out by dipping, roll coating, gravure coating, knife coating, air knife coating, roll knife coating, die coating, screen printing, spray coating, or gravure offset.

Drying of the applied film can for example be carried out by hot-air drying, hot-roll drying, or infrared irradiation. Although no specific limitations are placed on the drying temperature and time, the drying temperature is normally from room temperature to 200°C and the drying time is normally from 0.1 minutes to 150 minutes.

Also, although no specific limitations are placed on the amount of the carbon nanotubes (A) in the dispersion liquid, the amount of the carbon nanotubes (A) is preferably from 0.001% by mass to 10% by mass of the total mass of the dispersion liquid, and more preferably from 0.01% by mass to 5% by mass.

### (2) Conductor containing carbon nanotubes or containing carbon nanotubes and metal nanostructures

Conductive films made for example from a composite metal oxide such as indium tin oxide (ITO) or indium zinc oxide (IZO) are generally used as the conductive films of the photoelectrode and the counter electrode. However, a preferable alternative that can be used is a conductor (also referred to below as conductive layer (I)) containing the carbon nanotubes (A) described above or containing the carbon nanotubes (A) and metal nanostructures.

That is to say, such a conductive film is highly advantageous for mass production because the conductive film can be formed by applying and drying a dispersion liquid in which the carbon nanotubes are dispersed or in which the carbon nanotubes and the metal nanostructure are dispersed, the dispersion liquid has favorable application properties, processability accuracy is significantly improved, and high-speed application by roll-to-roll and processed film manufacture are facilitated.

In addition, compared to a conventional configuration in which a composite metal oxide such as indium tin oxide (ITO) is used, conductivity and cell electricity generation efficiency can be increased. Therefore, light transmittance of the module base plate can be increased, for example by increasing the size of the open section, while also achieving a balance with manufacturability.

The metal nanostructures described above are fine structures made from a metal or a metal compound and are used as a conductor.

No particular limitations are placed on the metal or metal compound composing the metal nanostructures other than being conductive. Possible examples include metals such as copper, silver, platinum and gold, metal oxides such as indium oxide, zinc oxide, and tin oxide, and composite metal oxides such as aluminum zinc oxide (AZO), indium tin oxide (ITO), and indium zinc oxide (IZO).

Among the above examples, silver or platinum is preferable due to the ease of obtaining excellent conductivity and transparency.

Examples of possible metal nanostructures include metal nanoparticles, metal nanowires, metal nanorods, and metal nanosheets.

Among the metal nanostructures listed above, metal nanoparticles are particulate structures having a nanometer scale average particle diameter. Although no specific limitations are placed on the average particle diameter of the metal nanoparticles (average particle diameter of primary particles), the average particle diameter is preferably from 10 nm to 300 nm. As a result of the average particle diameter being in the range described above, it is easier to obtain a conductive film having excellent conductivity and transparency.

The average particle diameter of the metal nanoparticles can be calculated by measuring the particle diameter of 100 randomly selected metal nanoparticles using a transmission electron microscope. The size of other metal nanostructures explained below can be obtained by the same method.

The metal nanoparticles can for example be obtained by a commonly known method such as a polyol method in which an organic complex is reduced by a polyhydric alcohol to synthesize metal nanoparticles or a reverse micelle method in which a reverse micelle solution including a reductant and a reverse micelle solution including a metal salt are mixed to synthesize metal nanoparticles.

Metal nanowires are linear structures having a nanometer scale average diameter and an aspect ratio (length/diameter) of at least 10. Although no specific limitations are placed on the average diameter of the metal nanowires, the average diameter is preferably from 10 nm to 300 nm. Also, although no specific limitations are placed on the average length of the metal nanowires, the average length is preferably at least 3 µm.

As a result of the average diameter and the average length being in the ranges described above, it is easier to obtain a conductive film having excellent conductivity and transparency.

The metal nanowires can for example be obtained by a commonly known method such as a method in which an applied voltage or current is imparted on the surface of a precursor from a tip of a probe and a metal nanowire is pulled out by the probe tip to continuously form the metal nanowire (JP2004-223693) or a method in which a nanofiber made from a metal composite peptide lipid is reduced (JP2002-266007).

Metal nanorods are cylindrical structures having a nanometer scale average diameter and an aspect ratio (length/diameter) of at least 1 and less than 10. Although no specific limitations are placed on the average diameter of the nanorods, the average diameter is preferably from 10 nm to 300 nm. Also, although no specific limitations are placed on the average length of the nanorods, the average length is preferably from 10 nm to 3,000 nm.

As a result of the average diameter and the average length being in the ranges described above, it is easier to obtain a conductive film having excellent conductivity and transparency.

The metal nanorods can for example be obtained by a commonly known method such as electrolysis, chemical reduction, or photoreduction.

Metal nanosheets are sheet-shaped structures having a nanometer scale thickness. Although no specific limitations are placed on the thickness of the metal nanosheets, the thickness is preferably from 1 nm to 10 nm. Also, although no specific limitations are placed on the size of the metal nanosheets, a side length of the metal nanosheets is preferably from 0.1 µm to 10 µm. As a result of the thickness and the side length being in the ranges described above, it is easier to obtain a conductive film having excellent conductivity and transparency.

The metal nanosheets can be obtained by a commonly known method such as a method in which a layered compound is peeled, chemical vapor deposition, or a hydrothermal method.

Among the metal nanostructures described above, use of metal nanowires is preferable in terms of ease of achieving excellent conductivity and transparency.

Any one of the types of metal nanostructures listed above or a combination of any two or more of the types of metal nanostructures listed above may be used.

Although no specific limitations are placed on the amount of the metal nanostructures in the conductive layer (I) described above, the amount is preferably from 0.0001 mg/cm² to 0.05 mg/cm².

Furthermore, the amount of the carbon nanotubes (A) in the conductive layer (I) is preferably from 1.0×10⁻⁶ mg/cm² to 30 mg/cm².

As a result of the amounts of the metal nanostructures and the carbon nanotubes (A) being in the ranges described above, conductivity and transparency are further improved.

Although no specific limitations are placed on the thickness of the conductive layer (I), the thickness is typically from 100 nm to 1 mm. As a result of the thickness of the conductive layer being in the range described above, favorable conductivity and transparency can be achieved.

The conductive layer (I) may contain other components such as a binder, a conductive additive, a dispersant, and a surfactant to the extent that such components do not adversely affect conductivity and transparency.

Furthermore, a conductive layer (also referred to as conductive layer (II)) containing the metal nanostructures described above may be further provided between the support and the conductive layer described above in each of the electrodes.

Although no specific limitations are placed on the amount of the metal nanostructures in the conductive layer (II), the amount is preferably from 0.0001 mg/cm² to 0.2 mg/cm². As a result of the amount of the metal nanostructures being in the range described above, conductivity and transparency can be further improved.

Although no specific limitations are placed on the thickness of the conductive layer (II), the thickness is normally from 30 nm to 1 mm. As a result of the thickness of the conductive layer (II) being in the range described above, favorable conductivity and transparency can be achieved.

The conductive layer (II) may contain components other than the metal nanostructures to the extent that such components do not adversely affect conductivity and transparency. Examples of other components that can be used are the same as the examples of other components given for the conductive layer (I).

Furthermore, other layers such as a hard coating layer, a gas barrier layer, and an adhesive layer may also be provided to the extent that such layers do not adversely affect conductivity and transparency. Such layers can be formed by commonly known conventional methods.

The conductive layer (I) described above can for example be obtained by preparing a dispersion liquid including the metal nanostructures and the carbon nanotubes (A), applying the dispersion liquid onto the support acting as a substrate, and drying the resultant applied film to form a conductive layer.

The dispersion liquid can be prepared in the same way as described above for formation of the catalyst layer. Furthermore, application and drying can also be carried out in the same way as described above for formation of the catalyst layer.

As explained above, in the photovoltaic device of the present disclosure, adoption of carbon nanotubes or metal nanoparticle-supporting carbon nanotubes in the catalyst layer of the counter electrode of the dye-sensitized solar cell or adoption of conductors containing carbon nanotubes or containing carbon nanotubes and metal nanostructures as the conductive films of the photoelectrode and the counter electrode of the dye-sensitized solar cell can substantially reduce manufacturing cost. Furthermore, such a catalyst layer or conductive film is highly advantageous for mass production because the layer or film can be formed through application and drying of a dispersion liquid in which the carbon nanotubes are dispersed, the dispersion liquid has favorable application properties, processability accuracy is significantly improved, and high-speed application by roll-to-roll and processed film manufacture are facilitated.

In addition, compared to a conventional configuration in which a platinum thin-film or indium tin oxide (ITO) is used, catalytic activity and conductivity can be raised, and cell electricity generation efficiency can be increased. Therefore, light transmittance of the module base plate can be increased, for example by increasing the size of the open section, while also achieving a balance with manufacturability.

### [Method for manufacturing photovoltaic device]

The following explains a method for manufacturing the photovoltaic device of the present disclosure.

Although no specific limitations are placed on manufacture of the photovoltaic device of the present disclosure, the photovoltaic device can for example be manufactured by stacking and electrically connecting two or more layers of organic photoelectric conversion module base plates that are each formed by arranging photoelectric conversion elements described above on a transparent substrate at fixed intervals such that the elements occupy a specific proportion of area of the resultant organic photoelectric conversion module base plate and electrically connecting the photoelectric conversion elements to one another by collection wiring. Formation of the photoelectric conversion elements, patterning of the collection wiring, and so forth can be carried out in accordance with commonly known methods.

Among such methods, a particularly suitable method includes a process in which two or more layers of organic photoelectric conversion module base plates are stacked by forming two or more organic photoelectric conversion module base plate units that are electrically connected to one another on a transparent substrate and folding back between adjacent units to cause overlapping of the adjacent units. The above-described method improves the yield and also, for example, enables manufacture by a roll-to-roll process when carbon nanotubes are used in formation of the photoelectric conversion elements, enables cost reduction, and enables reliable and efficient manufacture of the photovoltaic device of the present disclosure. In the method described above, open sections and photoelectric conversion element sections are preferably provided in the adjacent units such that when folding back is performed between the adjacent units to cause overlapping of the adjacent units, among units that are adjacent in the stacking direction, at least part of the open section of the unit located on one side in the stacking direction overlaps in the stacking direction with at least part of the photoelectric conversion element section of the unit located on an opposite side in the stacking direction. Note that formation of the organic photoelectric conversion module base plate units on the transparent substrate can be carried out in accordance with the formation method for an organic photoelectric conversion module base plate described above. The organic photoelectric conversion module base plate units may be formed in an arrangement such that the position of the collection wiring relative to the transparent substrate is the same for each unit, may be formed in an arrangement such that the position of the collection wiring relative to the transparent substrate is different for each unit, or may be formed in an arrangement which is a mixture of the arrangements described above.

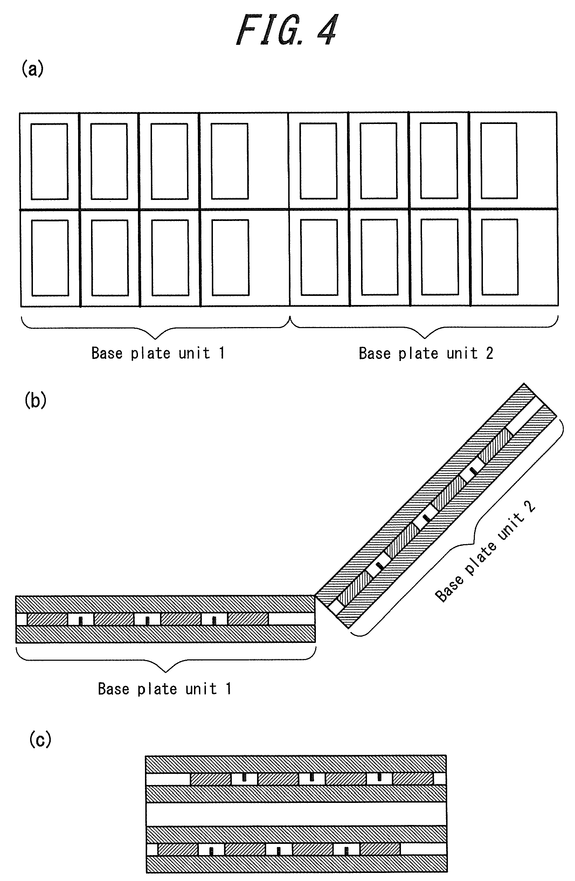

FIG. 4 is a process diagram illustrating an example of the particularly preferable method for manufacturing the photovoltaic device of the present disclosure described above. In the embodiment in FIG. 4, by (a) forming two base plate units on a transparent substrate with each of the units being the same as the organic photoelectric conversion module base plate illustrated in FIG. 3, and (b) performing folding back between adjacent units to cause overlapping of the adjacent units and form two layers of organic photoelectric conversion module base plates, the photovoltaic device of the present disclosure is manufactured (c) in which, among organic photoelectric conversion module base plates that are adjacent in the stacking direction, at least part of the open section of the organic photoelectric conversion module base plate located on one side in the stacking direction overlaps with at least part of the photoelectric conversion element section of the organic photoelectric conversion module base plate located on an opposite side in the stacking direction. It should be noted that the organic photoelectric conversion module base plate units may alternatively be caused to overlap in the opposite direction to that illustrated in (b).

### EXAMPLES

### (Example 1)

A photovoltaic device including two layers of stacked organic photoelectric conversion module base plates was obtained by forming two organic photoelectric conversion module base plate units that were electrically connected to one another on a transparent substrate and subsequently performing folding back between the adjacent units to cause overlapping of the adjacent units. In each of the base plate units, four dye-sensitized solar cells were arranged and connected in series such that a proportion of module base plate area occupied by a photoelectric conversion element section was 50%. Each of the dye-sensitized solar cells had the same area.

In each of the dye-sensitized solar cells, the catalyst layer of the counter electrode was formed by SGCNTs (carbon nanotubes composed mainly of single-walled CNTs, 3σ/Av = 0.58 (Av: average diameter, σ: diameter standard deviation), average diameter (Av) 3.3 nm, diameter distribution (3σ) 1.9 nm, specific surface area 804 m²/g, average length 500 µm, micropore volume 0.44 mL/g) prepared by a super growth method in accordance with the contents of WO2006/011655, and conductors containing the same carbon nanotubes were used as the conductive films of the photoelectrode and the counter electrode. Other aspects of configuration were the same as in a conventional dye-sensitized solar cell.

### (Example 2)

A photovoltaic device including three layers of stacked organic photoelectric conversion module base plates was obtained in the same way as in Example 1 in all aspects other than that three organic photoelectric conversion module base plate units were formed on the transparent substrate and the proportion of module base plate area occupied by the photoelectric conversion element section was 35% for each of the base plate units.

### (Comparative Example 1)

A photovoltaic device including a single organic photoelectric conversion module base plate layer was obtained by forming an organic photoelectric conversion module base plate for which the proportion of module base plate area occupied by a photoelectric conversion element section was 75% using dye-sensitized solar cells having the same configuration as in Example 1 in all aspects other than that a platinum thin-film was used as the catalyst layer of the counter electrode and indium tin oxide (ITO) was used for the conductive films of the photoelectrode and the counter electrode.

**[Table 1]**

| | No. of module base plate stacked layers | Proportion of module base plate area occupied by photoelectric conversion element section (%) | |
|---|---|---|---|
| Example 1 | 2 | First layer | 50 |
| | | Second layer | 50 |
| Example 2 | 3 | First layer | 35 |
| | | Second layer | 35 |
| | | Third layer | 35 |
| Comparative Example 1 | 1 | First layer | 75 |

Electricity generation, manufacturability, and processability of the photovoltaic devices obtained as described above were evaluated as follows.

### [Evaluation of electricity generation]

Each of the photovoltaic devices obtained as described above was connected to a sourcemeter (Series 2400 SourceMeter produced by Keithley Instruments) under illumination conditions of 10,000 lux and electricity generation was measured. The measurement results are shown in Table 2.

It should be noted that results are shown as ratios relative to a standard value; herein, the standard value is set as a value of electricity generation (and voltage) per unit area of the device in Comparative Example 1.

### [Evaluation of manufacturability and processability]

With regards to manufacturability and processability, difficulty of (a) patterning, (b) electrode bonding, and (c) module base plate assembly in the manufacturing process of each of the photovoltaic devices was evaluated in accordance with the three levels shown below. The evaluation results are also shown in Table 2.

Excellent: Implementable in a short period of time, without defects, etc., through standard control
Good: Implementable without defects, etc., through standard control
Fair: Implementable without defects, etc., through precise control

**[Table 2]**

| | Electricity generation | Voltage | Manufacturability and processability | | |
|---|---|---|---|---|---|
| | | | (a) Patterning | (b) Bonding | (c) Assembly |
| Example 1 | 1.8 | 1 | Excellent | Excellent | Excellent |
| Example 2 | 1.8 | 1 | Excellent | Excellent | Good |
| Comparative Example 1 | 1 | 1 | Fair | Fair | Excellent |

Table 2 indicates that electricity generation in Examples 1 and 2 was 1.8 times higher than in Comparative Example 1 used as the reference, thereby demonstrating that device electricity generation was substantially improved in Examples 1 and 2. Furthermore, manufacturability and processability in device manufacture were highly favorable for Examples 1 and 2.

### REFERENCE SIGNS LIST

- 10: photoelectrode
- 10a: photoelectrode base plate
- 10b: porous semiconductor fine particulate layer
- 10c: sensitizing dye layer
- 10d: support
- 10e: conductive film
- 20: electrolyte layer
- 30: counter electrode
- 30a: support
- 30b: catalyst layer
- 30c: conductive film
- 40: external circuit
- 50: photovoltaic device
- 50a: side wall
- 60: organic photoelectric conversion module base plate
- 60a: substrate
- 60b: photoelectric conversion element
- 60c: collection wiring
- 60d: open section

## Claims

1. A photovoltaic device comprising
two or more layers of organic photoelectric conversion module base plates that are stacked and connected, and that each include one or more photoelectric conversion elements, wherein
from 20% to 80% of area of each of the organic photoelectric conversion module base plates is occupied by a photoelectric conversion element section.

2. The photovoltaic device of claim 1, wherein
each of the organic photoelectric conversion module base plates further includes an open section, and
among organic photoelectric conversion module base plates that are adjacent in a stacking direction, at least part of an open section of an organic photoelectric conversion module base plate located on one side in the stacking direction overlaps in the stacking direction with at least part of a photoelectric conversion element section of an organic photoelectric conversion module base plate located on an opposite side in the stacking direction.

3. A method for manufacturing a photovoltaic device, comprising
stacking two or more layers of organic photoelectric conversion module base plates by forming two or more connected organic photoelectric conversion module base plate units on a transparent substrate and folding back between adjacent units to cause overlapping of the adjacent units, wherein
each of the units includes one or more photoelectric conversion elements, and
from 20% to 80% of area of each of the units is occupied by a photoelectric conversion element section.

4. The method for manufacturing a photovoltaic device of claim 3, wherein
each of the units further includes an open section, and
open sections and photoelectric conversion element sections are provided in the adjacent units such that when folding back is performed between the adjacent units to cause overlapping of the adjacent units, among units that become adjacent in a stacking direction, at least part of an open section of a unit located on one side in the stacking direction overlaps in the stacking direction with at least part of a photoelectric conversion element section of a unit located on an opposite side in the stacking direction.
